Europäisches Patentamt

European Patent Office

Office européen des brevets

(19)

(11) **EP 0 980 538 B1**

(12) **FASCICULE DE BREVET EUROPEEN**

(45) Date de publication et mention
de la délivrance du brevet:
**24.04.2002 Bulletin 2002/17**

(21) Numéro de dépôt: **98924404.1**

(22) Date de dépôt: **07.05.1998**

(51) Int Cl.[7]: **G02F 1/35**, H04B 10/18

(86) Numéro de dépôt international:
**PCT/FR98/00926**

(87) Numéro de publication internationale:
**WO 98/50824 (12.11.1998 Gazette 1998/45)**

(54) **DISPOSITIF ET PROCEDE DE REGENERATION POUR TRAIN DE SOLITONS**

VERFAHREN UND VORRICHTUNG ZUM REGENERIEREN VON SOLITONENFOLGEN

DEVICE AND METHOD FOR REGENERATING A TRAIN OF SOLITONS

(84) Etats contractants désignés:
**AT BE CH DE ES FR GB IT LI NL SE**

(30) Priorité: **07.05.1997 FR 9705637**

(43) Date de publication de la demande:
**23.02.2000 Bulletin 2000/08**

(73) Titulaire: **ALCATEL**
**75008 Paris (FR)**

(72) Inventeurs:
• **BIGO, Sébastien**
**F-91120 Palaiseau (FR)**
• **DUCELLIER, Thomas**
**Ottawa, Ontario K1N 6B9 (CA)**

(74) Mandataire: **Smith, Bradford Lee**
**COMPAGNIE FINANCIERE ALCATEL**
**Dépt. Propr. Industrielle,**
**30, avenue Kléber**
**75116 Paris (FR)**

(56) Documents cités:
• BIGO S ET AL: "Analysis of soliton in-line regeneration through two-wavelength nonlinear loop mirror as synchronous amplitude/phase modulator" ELECTRONICS LETTERS, 7 DEC. 1995, UK, vol. 31, no. 25, ISSN 0013-5194, pages 2191-2192, XP002052734
• EISELT M ET AL: "SLALOM: SEMICONDUCTOR LASER AMPLIFIER IN A LOOP MIRROR" JOURNAL OF LIGHTWAVE TECHNOLOGY, vol. 13, no. 10, octobre 1995, pages 2099-2112, XP000604371 cité dans la demande
• KANE M G ET AL: "ASYMMETRIC OPTICAL LOOP MIRROR: ANALYSIS OF AN ALL-OPTICAL SWITCH" APPLIED OPTICS, vol. 33, no. 29, 10 octobre 1994, pages 6833-6842, XP000473152
• OKHOTNIKOV O G ET AL: "PULSE GENERATION THROUGH OPTICAL SWITCHING IN PHASE DRIVEN LOOP MIRROR" ELECTRONICS LETTERS, vol. 31, no. 25, 7 décembre 1995, page 2197/2198 XP000546813 cité dans la demande
• FRANCOIS P -L ET AL: "Reduction of averaged soliton interaction forces by amplitude modulation" OPTICS LETTERS, 15 APRIL 1993, USA, vol. 18, no. 8, ISSN 0146-9592, pages 583-585, XP002052735 cité dans la demande

**Description**

La présente invention concerne un dispositif de régénération pour train de solitons et trouve application dans des réseaux de télécommunication.

Pour réaliser des liaisons de télécommunication à grande distance il est bien connu de faire porter une information à transmettre par un train d'impulsions optiques. Un tel train est rythmé c'est à dire qu'il définit des instants d'horloge se succédant régulièrement à une fréquence prédéterminée constituant une "fréquence bit", l'information à transmettre étant portée sous forme binaire par la présence ou l'absence d'une impulsion à chacun des instants d'horloge successifs. Il est également bien connu que ces impulsions peuvent avantageusement être émises sous la forme de solitons dans les fibres qui doivent les guider. On sait qu'un tel soliton est adapté à la fibre qui doit le guider et qu'il est alors caractérisé par un profil temporel d'amplitude spécifique, par une très faible durée à mi-hauteur, et par une grande pureté spectrale. Il présente au moins théoriquement l'avantage de se propager dans cette fibre sans subir de déformations cumulatives, ceci grâce à une compensation des effets de la dispersion chromatique et de la non linéarité, dite effet Kerr, propres à cette fibre. Cette compensation nécessite cependant que la puissance de l'impulsion soit maintenue en moyenne au cours de sa propagation. Or des pertes de puissance sont inévitables. C'est pourquoi ces pertes doivent être compensées à l'aide d'une succession d'amplificateurs optiques répartis le long de la liaison. Ces amplificateurs sont typiquement constitués par des fibres dopées à l'erbium et pompées optiquement. Cette nécessité de compenser les pertes de puissance des impulsions fait notamment apparaitre deux phénomènes parasites liés à l'émission spontanée des amplificateurs : l'un est la gigue de Gordon-Haus qui consiste en un déplacement aléatoire de chaque soliton au sein du train de solitons d'un côté et de l'autre de l'instant d'horloge correspondant. L'autre est une accumulation de bruit. Ces deux phénomènes parasites peuvent entrainer une détérioration de la qualité, c'est à dire une augmentation du taux d'erreur de la transmission.

L'une des méthodes connues pour éviter ces inconvénients consiste en une modulation synchrone d'un train d'impulsions optiques ou plus particulièrement de solitons. Une telle modulation réalise une régénération d'un train de solitons. En effet elle rapproche les solitons de leurs positions et de leurs profils temporels corrects et elle élimine ou du moins réduit le bruit. Son principe a été décrit dans un article de H. Kubota et Nakazawa, "Soliton transmission control in time and frequency domains", IEEE J. Quantum Electronics v. 29, n° 7, pp. 2189-2197, July 1993. Une expérience de transmission à 10 Gbit/s sur 1 million de kilomètres est décrite dans un article de Nakazawa et al., (1991), "Experimental demonstration of soliton data transmission over unlimited distance with soliton control in time and fréquency domains", Electronics Letters, v.29, n°9, pp. 729-730, 29 avril 1993.

Par ailleurs un système de régénération d'un train d'impulsions de lumière est décrit dans un article de J. K. Lucek et K. Smith, (1993) "Ail optical signal regenerator", Opt. Lett. v. 18, n° 15, pp. 1226-1228, 1 aug. 1993. On peut également citer une communication de D. Sandel et al., : "Polarization-independent regenerator with nonlinear optoelectronic phase-locked loop", Optical Fiber Conference Proceedings 1994, paper FG2.

Un article de M. Eiselt, W. Piper, and H.G. Weber "SLALOM : Semiconductor Laser Amplifier in a Loop Mirror", Journal of Lightwave Technology, vol. 13, n° 10, October 1995, pp2099- 2112 décrit un type de dispositif appelé SLALOM. Il indique notamment que ce dispositif peut être utilisé pour réaliser une régénération synchrone comme décrit dans le paragraphe : "SLALOM as Optical Retiming Device". Il ne décrit pas spécifiquement les éléments essentiels d'un régénérateur, c'est à dire d'un dispositif de régénération, mais plutôt ceux d'un dispositif expérimental permettant d'étudier les possibilités d'un tel régénérateur. Un régénérateur qui correspondrait aux indications de cet article sera désigné ci-après par l'appellation "régénérateur SLALOM antérieurement proposé".

Certains des éléments essentiels d'un tel régénérateur antérieurement proposé présentent des analogies avec les éléments d'un dispositif selon cette invention. Ces éléments sont les suivants:

- Un guide optique s'étendant entre d'une part une entrée pour recevoir un signal porteur d'information constitué par un train d'impulsions à régénérer, d'autre part une sortie pour fournir un train d'impulsions régénéré portant la même information. Les impulsions du train à régénérer ont une longueur d'onde d'entrée. Ce train présente un rythme de sorte qu'il permet de définir des instants d'horloge se succédant à une fréquence bit. Un segment de ce guide constitue une boucle interférométrique. Cette boucle est fermée par un coupleur de bouclage couplant ce guide à lui même à deux extrémités de cette boucle pour constituer un interféromètre de Sagnac.

- Un amplificateur de boucle constitué par un amplificateur laser à semiconducteur est raccordé en série dans la boucle interférométrique à distance d'un point milieu de cette boucle. Cette distance le long de ce guide sera appelée ci-après "distance de décalage".

- Enfin une source d'horloge fournit un signal de nature optique définissant des instants d'horloge correspondant au train d'impulsions à régénérer. Ce signal est injecté dans la boucle interférométrique pour y faire apparaitre une modulation croisée entre lui même et les impulsions de ce train. Sa longueur d'onde sera appelée longueur d'onde d'horloge.

Dans le régénérateur SLALOM antérieurement proposé la source d'horloge fournit son signal mentionné ci-dessus sous la forme d'impulsions d'horloge. Ces impulsions sont fournies à l'entrée du guide de la boucle interférométrique. Des composantes sont dérivées des impulsions du signal porteur d'information et des impulsions d'horloge par le coupleur de bouclage. Elles circulent dans la boucle interférométrique dans deux sens opposés. Celles qui sont dérivées du signal porteur d'information provoquent une saturation temporaire de l'amplificateur de boucle. La distance de décalage mentionnée ci-dessus est alors choisie de manière que celles qui sont dérivées des impulsions d'horloge rencontrent cet amplificateur dans un état saturé ou dans un état non saturé selon leurs positions temporelles par rapport aux précédentes. Dans le cas où les deux composantes dérivées d'une impulsion d'horloge ont rencontré l'amplificateur dans deux états de saturation différents, elles interfèrent positivement dans le coupleur de bouclage de sorte que cette impulsion d'horloge est transmise à la sortie du guide de la boucle interférométrique. Ce cas se produit lorsque le signal porteur d'information comportait une impulsion dans une position temporelle convenable par rapport à l'impulsion d'horloge, c'est à dire lorsque ce signal porteur d'information a ouvert une fenêtre temporelle pour l'impulsion d'horloge. Le dispositif fonctionne donc comme une porte commandée par le signal porteur d'information. L'information est ainsi transférée au train d'impulsions constitué par celles des impulsions d'horloge qui sont transmises à la sortie du guide. Ce nouveau signal porteur d'information est donc fourni à la longueur d'onde d'horloge.

Il apparait d'autre part que, dans ce régénérateur antérieurement proposé, la distance de décalage est définie en fonction de la durée de l'état de saturation provoqué dans l'amplificateur de boucle par chaque impulsion du signal portant initialement l'information. Cette distance est donc définie en fonction de la durée de vie des porteurs de charge dans cet amplificateur.

Ce régénérateur SLALOM antérieurement proposé présente l'avantage d'être du genre dit "tout optique", ce qui évite les limitations de bande passante liées à l'utilisation de signaux électroniques. Il semble devoir présenter divers autres avantages par rapport aux modulateurs connus du genre tout optique d'autres types. Ces avantages sont notamment que sa boucle interférométrique a une longueur beaucoup plus faible que celle des dispositifs du type NOLM et qu'ils ne nécessitent pas l'emploi de fibres à maintien de polarisation lorsque cette boucle est constituée par une fibre optique et lorsque le modulateur doit être insensible à la polarisation. Ces avantages sont importants parce que, d'une part il est parfois très souhaitable de réaliser le modulateur sous une forme intégrée, et parce que d'autre part un signal optique présente un état de polarisation aléatoire lorsqu'il a parcouru de grandes distances dans une liaison à fibres optiques. Ce régénérateur SLALOM antérieurement proposé semble cependant devoir présenter notamment l'inconvénient que son fonctionnement serait fortement dépendant des paramètres de fonctionnement qui définissent la durée de l'état de saturation provoqué dans l'amplificateur de boucle. De plus, dans le cas où il serait appliqué à la régénération d'un train de solitons, le signal de synchronisation devrait présenter lui même la forme d'un train de solitons que l'on pourrait appeler des solitons d'horloge. Il convient enfin de tenir compte du fait que la longueur d'onde du nouveau signal porteur d'information est différente de celle du signal reçu en entrée. Ce fait constituerait un inconvénient sérieux dans de nombreuses applications.

Un régénérateur pour train de solitons est aussi connu de l'article de S. Bigo et al, publié dans Electronic Letters, vol. 31 (1995), p. 2191-2.

La présente invention a notamment pour buts

- de rendre le fonctionnement d'un régénérateur du type Slalom peu sensible aux variations éventuelles des paramètres de fonctionnement de l'amplificateur de boucle à semi-conducteur inclus dans ce régénérateur,
- de conserver la longueur d'onde optique du signal porteur d'information,
- de manière plus générale de conserver les avantages du régénérateur Slalom antérieurement proposé tout en évitant ses inconvénients, et,
- de limiter autant que possible le taux d'erreur d'un système de transmission à fibres optiques dans lequel des informations à transmettre sont portées par des trains de solitons.

Dans ces buts un dispositif selon la revendication 1 est notamment caractérisé par le fait que la distance de décalage de l'amplificateur de boucle de ce dispositif est au moins égale à une valeur minimale, cette dernière étant égale à 20% d'un décalage nominal LN tel que

$$LN = c/2B.$$

De plus cette distance de décalage présente une différence au moins égale à cette valeur minimale par rapport à des valeurs interdites égales au produit de ce décalage nominal par un nombre entier pair, c étant la vitesse de la lumière dans ledit guide, B étant la fréquence bit définie par ledit rythme du train de solitons. Quant au signal représentatif des instants d'horloge du signal porteur d'information, ce signal représentatif est un signal de synchronisation dont l'enveloppe optique a une fréquence égale à la moitié de cette fréquence bit. Enfin l'amplitude et la phase de cette enveloppe du signal de synchronisation et une valeur moyenne de la puissance de ce signal sont telles que deux solitons parvenant à l'entrée de ce dispositif et occupant deux instants d'horloge immédiatement successifs dans un train de solitons soient transmis à la sortie de ce dispositif avec deux phases optiques mutuellement opposées.

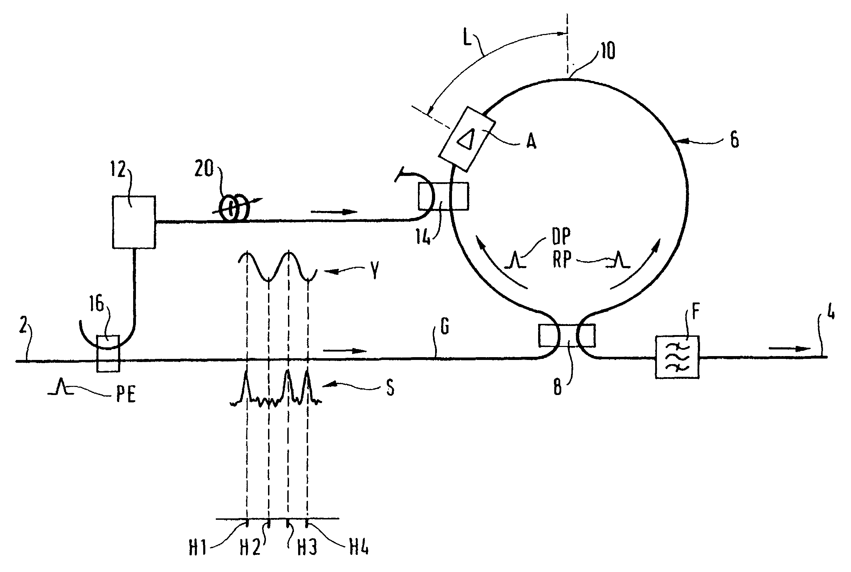

A l'aide de la figure schématique ci-jointe on va décrire ci-après à titre d'exemple non limitatif comment la présente invention peut être mise en oeuvre.

Cette figure représente un dispositif selon cette invention.

Ce dispositif comporte les éléments essentiels suivants :

- Un guide optique G s'étend entre d'une part, une entrée 2 pour recevoir un train de solitons S à régénérer, d'autre part une sortie 4 pour fournir un train de solitons régénéré. Ce guide peut être constitué par une fibre optique ou être formé sur un substrat dans le cas où le dispositif est réalisé sous forme intégrée. La longueur d'onde des solitons constitue une longueur d'onde d'entrée. Ce train présente un rythme de sorte qu'il permet de définir des instants d'horloge se succédant à une fréquence bit définie par ce rythme. Un segment de ce guide constitue une boucle interférométrique 6. Cette boucle est fermée par un coupleur de bouclage 8 couplant ce guide à lui même aux deux extrémités de cette boucle pour constituer un interféromètre de Sagnac. Le fonctionnement d'un tel interféromètre est bien connu et peut être approximativement décrit comme suit : Si une impulsion optique d'entrée telle que PE est reçue sur l'entrée 2, le coupleur 8 la divise en deux composantes DP et RP se propageant dans la boucle dans deux sens opposés. Ce coupleur applique alors un premier déphasage de $\pi/2$ à la composante RP par rapport à l'impulsion PE. Lorsque cette composante a fait le tour de la boucle ce coupleur lui applique un deuxième déphasage de $\pi/2$ avant de pouvoir la transmettre vers la sortie 4. Sur cette sortie cette composante se trouve en situation d'interférer avec la composante DP qui s'est propagée dans le guide sans subir de déphasage dans le coupleur 8. Cette interférence est constructive ou destructive selon d'éventuels autres déphasages subis par ces composantes dans leurs parcours respectifs dans la boucle 6. Le caractère constructif ou destructif de cette interférence résulte plus précisément de la différence entre deux valeurs totales présentées par ces autres déphasages respectivement pour ces deux composantes. Il en résulte que l'impulsion PE est transmise ou non à la sortie 4 selon la valeur d'un signal commandant cette différence.
- Un amplificateur de boucle A est constitué par un amplificateur laser à semiconducteur. Il est raccordé en série dans la boucle interférométrique à une certaine distance d'un point milieu 10 de cette boucle. Ce point milieu est celui qui est situé à égales distances des deux extrémités de celle-ci. La distance L entre l'amplificateur de boucle et ce point milieu le long de ce guide constitue la "distance de décalage ". Selon des dispositions caractéristiques de la présente invention cette distance de décalage L est au moins égale à la valeur minimale précédemment définie et elle présente une différence au moins égale à cette valeur minimale par rapport aux dites valeurs interdites.

- Enfin une source de synchronisation 12 fournit un signal de synchronisation Y de nature optique. Ce signal présente une longueur d'onde de synchronisation. Sa puissance varie au cours du temps de manière à définir les instants d'horloge H1....H4 du train de solitons S. Le signal de synchronisation Y est injecté dans l'amplificateur de boucle A pour y faire apparaitre une modulation croisée entre les solitons et ce signal. Cette injection est effectuée par un coupleur de synchronisation 14 sélectif en longueur d'onde.

Selon l'invention l'enveloppe optique du signal de synchronisation présente une fréquence égale à la moitié de la fréquence bit du train de solitons à régénérer. De plus l'amplitude et la phase de cette enveloppe et une valeur moyenne de la puissance de ce signal sont réglées pour que deux solitons parvenant à l'entrée 2 et occupant deux instants d'horloge immédiatement successifs tels que H3 et H4 dans le train de solitons S soient transmis à la sortie 4 avec inversion de leur relation de phase optique, c'est à dire que ces deux solitons sont transmis avec des phases mutuellement opposées dans le cas où ils étaient en accord de phase à l'entrée du dispositif.

Une telle opposition de phase entre deux impulsions optiques successives a été mentionnée dans un article de O.G. Okhotnikov et F. M. Araujo, intitulé "Pulse generation through optical switching in phase driven loop mirror", Electronics Letters 7th December 1995 Vol. 31 N°. 25. Cet article décrit un générateur d'impulsions optiques utilisant une boucle interférométrique constituant un interféromètre de Sagnac. L'amplificateur de cette boucle est en position décalée et il est commandé par un signal électrique dont la fréquence est la moitié de la fréquence de récurrence des impulsions générées. Ces impulsions sont alternativement dites brillantes (bright pulses) et sombres (dark pulses) en raison de l'alternance de leurs phases optiques. Les distances de décalage mentionnées sont différentes de celles de la présente invention.

Dans le cadre de la présente invention les solitons successifs peuvent être appelés "solitons adjacents". L'opposition de leurs phases optiques présente l'avantage de limiter fortement le risque que la qualité de la transmission soit dégradée par des phénomènes de collisions de solitons. Cet avantage d'une telle opposition de phase entre solitons adjacents était connu par un article de Pierre-Luc François et Thierry Georges, intitulé "Reduction of averaged soliton interaction forces by amplitude modulation", Optics Letters, April 15, 1993, vol.18, N° 8, pp 583 -585.

Il existe indépendamment de la présence d'une gigue temporelle ou d'un bruit dans le train de solitons à régénérer de sorte que le dispositif selon l'invention peut être utilisé avec avantage même si le train de solitons à régénérer n'est affecté ni par la gigue ni par le bruit. Contrairement à ce qu'une analyse trop sommaire pourrait laisser croire cet avantage ne disparait pas après une deuxième régénération synchrone.

Les dispositions nouvelles ci-dessus concernant la distance de décalage et la fréquence de l'enveloppe du signal de synchronisation permettent non seulement de réaliser une régénération synchrone efficace mais aussi d'obtenir l'avantage résultant de l'opposition de phase entre solitons adjacents. La présente invention enseigne que, lorque ces dispositions nouvelles ont été réalisées, il existe des valeurs de l'amplitude, de la phase et de la puissance moyenne du signal de synchronisation telles que cette opposition de phase soit réalisée. Ces dernières valeurs sont à la portée des spécialistes avec l'aide des indications ci-dessus, et de celles contenues notamment dans l'article précédemment cité décrivant les dispositifs SLALOM, seule une expérimentation normale étant alors nécessaire.

Dans le cadre de cette invention l'amplitude crête à crête du signal de synchronisation est fortement supérieure à celle qui serait nécessaire pour qu'une impulsion lumineuse d'entrée ayant la longueur d'onde d'entrée et reçue sur l'entrée 2 soit transmise ou non à la sortie 4 selon la relation de temps existant entre cette impulsion lumineuse et la modulation de ce signal de synchronisation. On peut préciser ce qui précède en considérant la différence de phases qui est induite dans l'amplificateur de boucle A entre deux composantes telles que DP et RP d'une telle impulsion lumineuse, ces deux composantes circulant dans la boucle interférométrique respectivement dans un sens direct et dans un sens rétrograde. Cette différence de phases est liée à la variation présentée par la puissance du signal de synchronisation entre les deux instants où ces composantes traversent respectivement cet amplificateur, ou du moins entre deux périodes précédant respectivement ces deux instants, la durée de ces périodes étant définie par la durée de vie des porteurs de charge dans cet amplificateur.

Dans le cadre de cette invention les valeurs de cette différence de phase correspondant à deux instants d'horloge successifs sont sensiblement symétriques par rapport à ta valeur correspondant à un instant médian entre ces deux instants d'horloge. Pour que le dispositif assure une régénération synchrone des solitons la valeur de la différence de phases correspondant à un tel instant médian doit interdire à une impulsion d'entrée d'être transmise à la sortie du dispositif. Il en résulte que l'amplitude de la modulation du signal de synchronisation est telle que l'écart entre les valeurs extrêmes de cette différence de phase est sensiblement le double de l'écart qui permettrait que l'impulsion lumineuse en question soit transmise ou éliminée selon sa relation de temps avec le signal de synchronisation.

Les variations de phase susceptibles d'être obtenues dans les amplificateurs connus susceptibles de constituer l'amplificateur de boucle sont pratiquement limitées notamment lorsque la puissance du signal de synchronisation provoquant ces variations est elle même limitée. C'est pourquoi, dans le cadre de cette invention, il est souhaitable de donner au moins approximativement à la distance de décalage des valeurs optimales permettant d'atteindre les buts de cette invention avec l'aide de valeurs aussi petites que possible de ces variations de phase. C'est pourquoi, de préférence la distance de décalage L est comprise entre 80% et 120% dudit décalage nominal LN éventuellement augmenté du produit de ce décalage nominal par un nombre entier pair. Ceci peut être notamment exprimé par les inégalités

$$0,8 < L/LN-2k < 1,2$$

k étant un nombre entier. Des valeurs optimales de décalage L sont approximativement données par l'expression : $(2k +1)$ LN. Les valeurs interdites de cette distance sont données par l'expression : $2k.LN$. Ces valeurs interdites sont celles pour lesquelles le dispositif ne pourrait pas fonctionner quelles que soient les caractéristiques de l'amplificateur de boucle et du signal de synchronisation. Les expressions donnant ces valeurs optimales et interdites deviennent exactes dans le cas où la modulation du signal de synchronisation provoque une variation sinusoïdale du déphasage introduit par l'amplification de boucle.

Selon un mode de réalisation typique la modulation du signal de synchronisation Y est sensiblement sinusoïdale.

De préférence le dispositif comporte en outre un filtre de longueurs d'onde F pour transmettre sélectivement à la sortie 4 la lumière présentant la longueur d'onde d'entrée.

De préférence encore la source de synchronisation 12 est pilotée par le train de solitons S par l'intermédiaire d'un coupleur de récupération d'horloge 16 et d'un guide pour constituer un organe de récupération d'horloge. Cet organe est muni de moyens d'adaptation de phase 20 pour conférer au signal de synchronisation une phase adaptée à ce train de solitons.

La source de synchronisation 12 peut comporter tout d'abord un dispositif de récupération d'horloge analogue à celui décrit dans un article de S. Kawanishi et M. Saruwatari, intitulé "New-type phase-locked loop using travelling-wave laser-diode optical amplifier for very high-speed optical transmission", Electronics Letters 10th November 1988 Vol. 24 N° 23, pp 1452-1453. Elle peut comporter ensuite un dispositif apte à donner une forme sinusoïdale et la fréquence voulue à l'enveloppe optique du signal résultant de la récupération d'horloge. Ce dernier dispositif peut être analogue à celui décrit dans un article de N. Onodera intitulé 'THz optical beat frequency generation by modelocked semiconductor lasers", Electronics Letters 23rd May 1996 Vol.32 N° 11, pp 1013-1014.

A titre d'indications numériques on peut indiquer que la fréquence bit B peut être de l'ordre de 5 GHz, que la longueur de la boucle interférométrique peut être comprise entre 5 cm et 100 m environ, par exemple voisine de 5 m, et que le décalage temporel induit par la distance de décalage entre les instants où les deux composantes d'une impulsion rencontrent l'amplificateur de boucle peut être donné par l'expression 2 n L/c = 35 ps, par exemple, n étant l'indice de réfraction vu par ces composantes dans la fibre constituant la boucle interférométrique.

## Revendications

1. Dispositif de régénération pour train de solitons, ce dispositif comportant

   - un guide optique (G) s'étendant entre d'une part une entrée (2) pour recevoir un train de solitons (S) à régénérer, d'autre part une sortie (4) pour fournir un train de solitons régénéré, ce train de solitons ayant une longueur d'onde d'entrée et présentant un rythme de sorte qu'il permet de définir des instants d'horloge de ce train se succédant à une fréquence bit B de ce train, un segment de ce guide constituant une boucle interférométrique (6), cette boucle étant fermée par un coupleur de bouclage (8) couplant ce guide à lui même à deux extrémités de cette boucle pour constituer un interféromètre de Sagnac, un point milieu (10) de cette boucle étant situé à égales distances de ces deux extrémités le long de ce guide,
   - une source de synchronisation (12) fournissant un signal de synchronisation (Y) de nature optique définissant des instants d'horloge (H1.... H4) pour ledit train de solitons, ce signal présentant une longueur d'onde de synchronisation et ayant une puissance variant selon une enveloppe optique de ce signal, cette enveloppe présentant une fréquence égale à la moitié de ladite fréquence bit et,
   - des moyens (14) injectant ledit signal de synchronisation (Y) dans ledit amplificateur de boucle (A) pour y faire apparaitre une modulation croisée entre lesdits solitons et ce signal de synchronisation, l'amplitude et la phase de ladite enveloppe du signal de synchronisation et une valeur moyenne de la puissance de ce signal étant telles que deux solitons parvenant à ladite entrée (2) et occupant deux instants d'horloge immédiatement successifs (H3, H4) dudit train de solitons (S) soient transmis à ladite sortie (4) avec inversion de leur relation de phase optique, ce dispositif étant **caractérisé en ce qu'**il comprend un amplificateur de boucle (A) constitué par un amplificateur laser à semiconducteur raccordé en série dans ladite boucle interférométrique, une distance étant présente entre cet amplificateur de boucle et ce point milieu le long de ce guide et constituant une distance de décalage L, ladite distance de décalage L étant au moins égale à une valeur minimale valant 20% d'un décalage nominal LN tel que

$$LN = c/2B,$$

cette distance de décalage présentant une différence au moins égale à cette valeur minimale par rapport à des valeurs interdites égales au produit de ce décalage nominal par un nombre entier pair, c étant la vitesse de la lumière dans ledit guide.

2. Dispositif selon la revendication 1, ce dispositif étant **caractérisé par le fait que** ladite distance de décalage (L) est comprise entre 80% et 120% dudit décalage nominal (LN) éventuellement augmenté du produit de ce décalage nominal par un nombre entier pair.

3. Dispositif selon la revendication 1, ce dispositif étant **caractérisé par le fait que** ladite modulation du signal de synchronisation (Y) est sensiblement sinusoïdale.

4. Dispositif selon la revendication 1, ce dispositif comportant en outre un filtre de longueurs d'onde (F) pour transmettre sélectivement à ladite sortie (4) la lumière présentant ladite longueur d'onde d'entrée.

5. Dispositif selon la revendication 1, ladite source de synchronisation (12) étant pilotée par ledit train de solitons par l'intermédiaire d'un coupleur de récupération d'horloge (16) et d'un guide pour constituer un organe de récupération d'horloge, cet organe étant muni de moyens d'adaptation de phase (20) pour conférer au dit signal de synchronisation une phase adaptée audit train de solitons.

6. Procédé de régénération pour train de solitons, procédé selon lequel on fait passer un train de solitons (S) dans un interféromètre de Sagnac (6) à amplificateur semiconducteur décalé (A) et on commande cet amplificateur par un signal de synchronisation optique (Y) modulé en amplitude à une fréquence moitié d'une fréquence bit de ce train, le décalage de cet amplificateur dans ledit interféromètre et les paramètres dudit signal de synchronisation étant tels que deux solitons adjacents dudit train soient transmis avec inversion de leur relation de phase optique.

**Patentansprüche**

1. Vorrichtung zum Regenerieren einer Solitonenfolge, mit:

einem optischen Leiter (G), der sich zwischen einerseits einem Eingang (2) zum Empfangen einer zu regenerierenden Solitonenfolge (S) und andererseits einem Ausgang (4) zum Liefern einer regenerierten Solitonenfolge erstreckt, wobei diese Solitonenfolge eine Eingangswellenlänge hat und einen solchen Rhythmus aufweist, dass er es erlaubt, Taktzeitpunkte dieser Folge zu definieren, die mit einer Bitfrequenz B dieser Folge aufeinanderfolgen, wobei ein Segment dieses Leiters eine Interferometerschleife (6) bildet, die Schleife durch einen Schleifenkoppler (8) geschlossen ist, der diesen Leiter an zwei Enden dieser Schleife an sich selbst koppelt, um ein Sagnac-Interferometer zu bilden, wobei ein Mittenpunkt (10) dieser Schleife in gleichen Abständen von diesen zwei Enden entlang des Leiters angeordnet ist,
einer Synchronisationsquelle (12), die ein Synchronisationssignal (Y) optischer Art liefert, das Taktzeitpunkte (H1, ... H4) für die Solitonenfolge festlegt, wobei das Signal eine Synchronisationswellenlänge hat und eine Leistung hat, die entsprechend einer optischen Umhüllenden dieses Signals variiert, wobei diese Umhüllende eine Frequenz gleich der halben Bitfrequenz aufweist, und Mitteln (14), die das Synchronisationssignal (Y) in den Schleifenverstärker (A) einspeisen, um dort eine Kreuzmodulation zwischen den Solitonen und dem Synchronisationssignal hervorzurufen, wobei die Amplitude und die Phase der Umhüllenden des Synchronisationssignals und ein Mittelwert der Leistung dieses Signals derart sind, dass zwei Solitonen, die an dem Eingang (2) eintreffen und zwei unmittelbar aufeinanderfolgende Taktzeitpunkte (H3, H4) der Solitonenfolge (S) belegen, an den Ausgang (4) unter Umkehrung ihrer optischen Phasenbeziehung übertragen werden, wobei die Vorrichtung **dadurch gekennzeichnet ist, dass** sie einen Schleifenverstärker (A) umfasst, der durch einen Halbleiter-Laserverstärker gebildet ist, der in der Interferometerschleife in Reihe geschaltet ist, wobei ein Abstand zwischen diesem Schleifenverstärker und dem Mittenpunkt entlang des Leiters vorhanden ist und
einen Verschiebungsabstand L darstellt, wobei der Verschiebungsabstand L wenigstens gleich einem Mindestwert von 20 % einer Nennverschiebung LN mit LN=c/2B ist, wobei dieser Verschiebungsabstand eine Differenz von wenigstens diesem Mindestwert in Bezug auf verbotene Werte aufweist, die gleich dem Produkt dieser Nennverschiebung mit einer geradzahligen ganzen Zahl sind, wobei c die Lichtgeschwindigkeit in dem Leiter ist.

2. Vorrichtung nach Anspruch 1, **dadurch gekennzeichnet, dass** der Verschiebungsabstand (L) zwischen 80 % und 120 %
der Nennverschiebung (LN) beträgt, eventuell vermehrt um das Produkt dieser Nennverschiebung mit einer geradzahligen ganzen Zahl.

3. Vorrichtung nach Anspruch 1, **dadurch gekennzeichnet, dass** die Modulation des Synchronisationssignals (Y) im Wesentlichen sinusförmig ist.

4. Vorrichtung nach Anspruch 1, ferner mit einem Wellenlängenfilter (F) zum selektiven Übertragen des die Eingangswellenlänge aufweisenden Lichtes an den Ausgang (4).

5. Vorrichtung nach Anspruch 1, bei der die Synchronisationsquelle (12) durch die Solitonenfolge über einen Taktwiedergewinnungskoppler (16) und einen Leiter zum Bilden eines Taktwiedergewinnungsorgans gesteuert ist, wobei dieses Organ mit Phasenanpassungsmitteln (20) versehen ist, um dem Synchronisationssignal eine an die Solitonenfolge angepasste Phase zu verleihen.

6. Regenerationsverfahren für eine Solitonenfolge, bei der eine Solitonenfolge (S) durch ein Sagnac-Interferometer (6) mit verschobenem Halbleiterverstärker (A) geführt wird und dieser Verstärker durch ein optisches Synchronisationssignal (Y) gesteuert wird, das mit einer Frequenz gleich der halben Bitfrequenz dieser Folge amplituden moduliert wird, wobei die Verschiebung dieses Verstärkers in dem Interferometer und die Parameter des Synchronisationssignals derart sind, dass zwei benachbarte Solitonen der Folge unter Umkehrung ihrer optischen Phasenbeziehung übertragen werden.

**Claims**

1. A system for regenerating a stream of solitons, the system comprising:

- an optical waveguide (G) between an input (2) for receiving a stream (S) of solitons to be regenerated and an output (4) at which a stream of regenerated solitons is supplied, the stream of solitons having an input wavelength and a clock rate defining successive clock times of the stream at a bit frequency B of the stream, a segment of the waveguide constituting an interferometer loop (6), the loop being closed by a loop coupler (8) coupling the waveguide to itself at two ends of the loop to constitute a Sagnac interferometer, a mid-point (10) of the loop being at equal distances along the waveguide from the two ends,

- a synchronization source (12) supplying an optical synchronization signal (Y) defining clock times (H1 ... H4) for said stream S of solitons and having a synchronization wavelength and a power varying in accordance with an optical envelope of the signal, the envelope having a frequency equal to half said bit frequency, and
- means (14) for injecting said synchronization signal (Y) into said loop amplifier (A) to bring about therein cross modulation between said solitons and the synchronization signal, the amplitude and the phase of said envelope of the synchronization signal and an average value of the power of the signal being such that two solitons reaching said input (2) and occupying two immediately successive clock times (H3, H4) of said stream (S) of solitons are transmitted to said output (4) with their optical phase relationship inverted, the system being **characterized in that** it further comprises a loop amplifier (A) constituted by a semiconductor loop amplifier connected in series in said interferometer loop, the distance along the waveguide between the loop amplifier and the mid-point constituting an offset distance L, said offset distance L being not less than a minimum value which is 20% of a nominal offset LN such that

$$LN = c/2B$$

the offset distance differing by at least this minimum value from illegal values equal to the product of the nominal offset multiplied by an even integer, $c$ being the speed of light in said waveguide.

2. A system according to claim 1, the system being **characterized in that** said offset distance (L) is in the range from 80% to 120% of said nominal offset (LN), possibly increased by the product of the nominal offset multiplied by an even integer.

3. A system according to claim 1, the system being **characterized in that** said modulation of the synchronization signal (Y) is substantially sinusoidal.

4. A system according to claim 1, the system further including a wavelength filter (F) for selectively transmitting light at said input wavelength to said output (4).

5. A system according to claim 1, said synchronization source (12) being controlled by said stream of solitons through the intermediary of a clock recovery coupler (16) and a waveguide constituting a clock recovery unit which has phase matching means (20) to impart to said synchronization signal a phase suitable for said stream of solitons.

6. A method of regenerating a stream of solitons, in which method a stream (S) of solitons enters a Sagnac interferometer (6) with an offset semiconductor amplifier (A) and the amplifier is controlled by an optical synchronization signal (Y) amplitude-modulated at a frequency which is half a bit frequency of the stream, the offset of the amplifier in said interferometer and the parameters of said synchronization signal being such that two adjacent solitons of said stream are transmitted with their optical phase relationship inverted.